# EUROPEAN PATENT SPECIFICATION

(11) **EP 1 367 880 B1**
(45) Date of publication and mention of the grant of the patent: **06.07.2011**
(21) Application number: 03101524.1
(22) Date of filing: 26.05.2003
(51) Int. Cl.: H05K 9/00

(54) **Screening device for printed circuit cards**
Abschirmvorrichtung für gedruckte Schaltungskarten
Dispositif de blindage pour cartes de circuit imprimé

(30) Priority: 31.05.2002 FR 0206675
(43) Date of publication of application: 03.12.2003
(73) Proprietor: Thomson Licensing, 92130 Issy-les-Moulineaux (FR)
(72) Inventor: Touze, David, 35200, RENNES (FR); Peuto, Serge, 35220, Chateaubourg (FR); Pintelon, Johan, B-8420, DE HAAN (BE)
(74) Representative: Kerber, Thierry

(56) References cited:
- EP-A- 0 534 372
- US-A- 4 739 453
- US-A- 5 905 641

## Description

The invention relates to a device for screening an electronic circuit card from electromagnetic radiation. The invention is especially applicable to a modem card for a personal computer.

In the field of personal computers, modems, such as DSL (Digital Subscriber Line) modems, are used for connecting the computer to a network or to any other data transmission circuit.

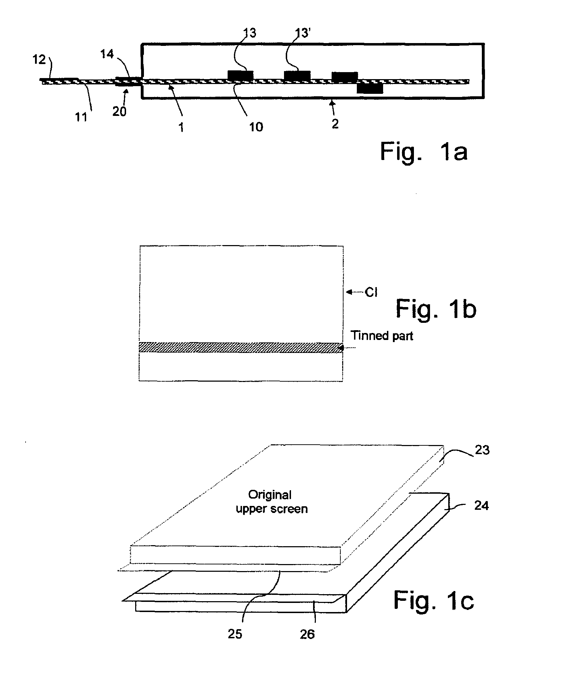

Figure 1a shows an example of a currently used modem. This modem essentially comprises a printed circuit card 1 placed at least partly in a case 2 made of an electrically conducting material and acting as an electromagnetic screen. This screen protects the circuits of the card from external electromagnetic interference, but also prevents any electromagnetic radiation from the modem card to the outside.

The card 1 possesses a part 10 placed inside the screen. This part 10 bears electronic circuits 13, 13' produced generally in the form of integrated circuits and delivering the digital part of the modem. The card 1 also possesses a part 11 placed outside the screen and bearing connection pads 12 connected to the circuits 13, 13' via connections (not shown). The part 11 of the card is designed to accommodate connectors for connecting, for example, the modem to the computer on the one hand, and to a transmission network on the other. The case contains the card such that it is sealed from the standpoint of electromagnetic waves and is especially in contact with both faces of the card in the region 14 located between the two parts 10 and 11 of the card.

Such a modem is designed to meet international standards on transmitted electromagnetic interference.

The printed circuit card may include, on both its faces, in the region 14, tinned contact pads that allow electrical contact with the screen. Figure 1b shows the printed circuit card seen from above, with the tinned part 14 hatched. This tinned part therefore exists on both faces of the card.

Such a modem is designed to operate by wire connections.

Patent US-5 905 641 discloses an electrical connection with electromagnetic compatibility. A screen case comprises a wall provided with a slot, through which part of a printed circuit card bearing an electrical connection may extend to the outside. The edges of the slot are provided with contact strips that are electrically conducting and elastically deformable, these being designed to grip the card by contact with an electrically conducting coating on the latter.

The subject of the present invention is a device for screening an electronic circuit card from electromagnetic radiation, making it possible for two cards to be mounted in the same screening case, while allowing a construction that is inexpensive and practical to implement. The screening device of the invention may be particularly suitable for wireless transmission and may permit two cards of different widths to be mounted.

The invention therefore relates to a device for screening an electronic circuit card from electromagnetic radiation, comprising a case made of electrically conducting material. This case is provided with a slot into which a first part of a first electronic circuit card is placed, a second part of this first card being located outside the case. A compressible conducting material located between the edges of the slot in the case and the faces of the first card is also provided.

According to the invention, the case is designed to also accommodate a second electronic circuit card and the device also includes a "Z"-shaped linking piece for electrically connecting the two cards together, a lower flat part of this piece being in contact with the second card and an upper flat part of this piece being in contact with the first card via a seal made of conducting material.

Advantageously, the device includes the first card and the faces of this first card have metallized regions in those regions in contact with the compressible conducting material.

According to a preferred embodiment, at least one of the edges of the slot in the case forms a rim bent back parallel to the plane of the first card.

The invention is applicable to the situation in which, when the device includes both cards, the second card is a modem card and the first card is a communication card having an antenna circuit in its second part.

It is particularly advantageous to apply the invention to the case in which the first card has a smaller width than the width of the second card. The case is then preferably designed in two parts. The lower part of the case is designed to be in electrical contact with a first face of the second card. The upper part of the case is designed to be in contact with a second face of the second card, except in the region of said slot. The upper part of the slot is designed to be in contact with a first face of the first card, while the second face of the first card is designed to be in electrical contact with the second face of the second card via the seal and the linking piece.

Advantageously, the device therefore includes another conducting seal designed to be placed between the first card and the upper part of the slot.

The invention is thus especially applicable to the case in which the second card (modem) and the case are items of equipment of known type and the slot is made in the case so as to place the first card (communication card) therein with, on the one hand, a conducting seal between the first card and one edge of the slot and with, on the other hand, the "Z"-shaped piece and a seal between the first card and the second card.

The various objects and features of the invention will become more clearly apparent in the following description given by way of non-limiting example and in the appended figures, which show:
- Figures 1a to 1c, a modem known in the art and already described above;
- Figure 2, an illustrative embodiment of a device according to the invention;
- Figures 3a to 3c, details of the device shown in Figure 2; and
- Figure 4, a simplified example of a PCMCIA card of known type.

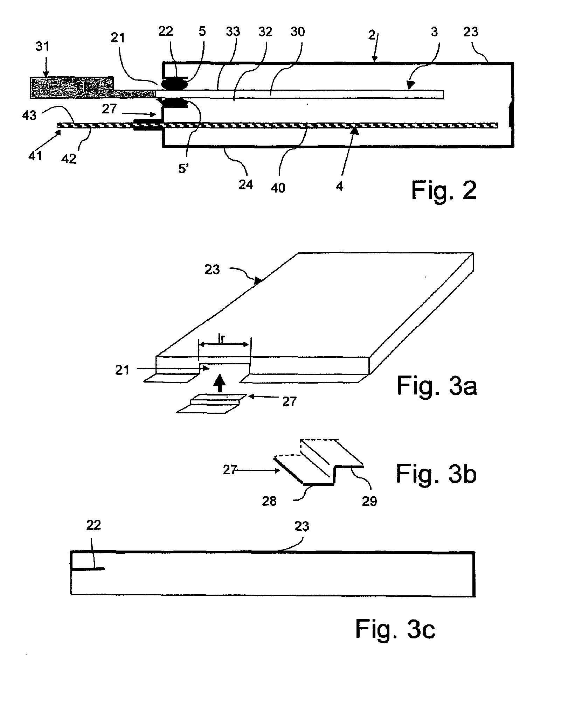

In general, the invention is applicable to screening a digital circuit card from electromagnetic radiation, said card being equipped with electronic circuits and having a part that cannot be inside the screen because of connections to the outside. This is the case, for example, of a modem card that may be connected to a personal computer in order to connect the latter to an external network, such as a telecommunication network. According to the invention, the part 30 of a card 3 that has to be protected by a screen is placed in a case 2, with its unprotected part 31 extending outside the case via a slot 21 (see Figure 2). As the slot 21 is provided with edges, a seal 5, 5' made of a deformable and electrically conducting material is placed between the faces 32 and 33 of the card and the edges of the slot 21.

The invention is applicable to adapting a case for screening a modem card of the type used in computing for personal computers, such as the abovementioned DSL modems, in order to join it to a transmission card, such as a wireless transmission card. For example, provision made be made to join a wireless transmission card, of the type known in the art by the name PCMCIA (Personal Computer Memory Card International Association) card, to the modem card. Such a PCMCIA card possesses a digital electronic circuit part corresponding to the part 30 of the card 3 and an antenna corresponding to the part 31. The part 30 of this card is approximately the size of a bank card.

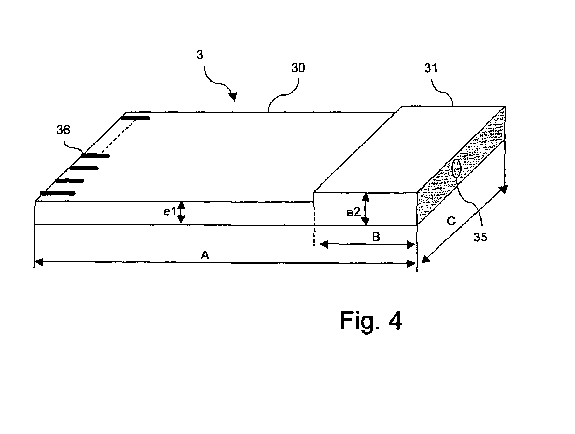

Figure 4 shows a simplified representation of a PCMCIA card with its electronic circuit part 30 and its antenna part 31. To give an example, the dimensions of such a card are: A = 117.8 cm, B = 22.3 cm, C = 53.95 cm, e1 = 5 mm and e2 = 8.7 mm. The left-hand end of the electronic part 30 of the card possesses a connector 36 for connecting the card to the inside of the screening case. The part 31 possesses on its righthand end various means of operation, such as an antenna socket 35.

As shown in Figure 2, a PCMCIA-type card 3 is designed to be placed in the same case as a card 4 of DSL modem card type, possessing an electronic circuit part 40 and a part 41 for external connections. The card 4 is connected to the screening case in a known manner by making the faces 42 and 43 of the card 4 come into contact with two rims 25 and 26 of the two parts 23 and 24 of the case 2, as shown in Figures 1a and 1c.

The card 3 is substantially narrower than the card 4. To place it in the case 2, a slot is provided with a width limited to the width of the card 3. A slot is made in the upper part 23, shown in Figure 1c, of the case, the width 1r of the slot, such as the slot 21 shown in Figure 3a, being sufficient to allow the card 3 to be placed therein. As shown in Figure 3c, this slot may be produced by cutting the side of the upper part 23 of the case and bending the cut part back towards the inside of the case so as to produce an upper rim 22.

A Z-shaped piece 27 having two flat parts 28 and 29 is also manufactured. The flat part 28 is designed to be pressed against the upper face of the card 4. The flat part 29 is designed to be placed facing the rim 22. The card 3 is placed between the rim 22 and the flat part 29 with the electronic circuit part 30 located inside the case. Provided, on the one hand, between the card 3 and the rim 22 and, on the other hand, between the card 3 and the flat part 29 of the piece 27 are respective seals 5 and 5' made of deformable and electrically conducting material.

The invention therefore makes it possible to adapt a case for screening a modem card in order to join it to a communication card, such as a wireless transmission card, for example of the PCMCIA card type. The invention described offers the possibility of optionally being able to remove the card 3 without having to dismantle the case 2.

It should be noted that the card 3 may be electrically connected to the card 4 by means (not shown) falling outside the context of the invention.

The electrically conducting deformable material may be a conducting adhesive foam known in the art.

The Z-shaped piece 27 will allow the card 3 to be pressed from underneath. In addition, the combination of the two pieces of conducting adhesive foam 5 and 5' makes it possible to grip the card 3 on its digital electronics part, the faces of which advantageously have conducting pads in this region. Electrical continuity of the screen, maintaining its qualities from the electromagnetic interference standpoint, and mechanical retention of the card 3 are thus ensured at lower cost.

## Claims

1. Device for screening an electronic circuit card from electromagnetic radiation, comprising a case (2), made of electrically conducting material, provided with a slot (21) into which a first part (30) of a first electronic circuit card (3) is placed, a second part (31) of this first card being located outside the case, said screening device also including a compressible conducting material (5, 5') located between the edges of the slot (21) in the case (2) and the faces (32, 33) of the first card (3), said case being designed to also accommodate a second electronic circuit card (4), **characterized in that** said device also includes a "Z"-shaped linking piece (27) for electrically connecting the two cards together, a lower flat part (28) of this piece being in contact with the second card (4) and an upper flat part (29) of this piece being in contact with the first card via a seal (5') made of electrically conducting material.

2. Screening device according to Claim 1, **characterized in that** it includes said first card (3) and **in that** the faces of said first card have metallized regions in those regions in contact with the compressible conducting material (5, 5').

3. Screening device according to either of Claims 1 and 2, **characterized in that** at least one of said edges of said slot (21) in the case (2) forms a rim (22) bent back parallel to the plane of said first card (3).

4. Screening device according to any one of the preceding claims, **characterized in that**, when said device includes both cards, the second card (4) is a modem card and the first card (3) is a communication card having an antenna circuit in its second part (31).

5. Screening device according to any one of the preceding claims, **characterized in that** the case (2) is designed so that the first card (3) has a smaller width than the width of the second card (4).

6. Screening device according to any one of the preceding claims, **characterized in that** the case is made in two parts (23, 24), the lower part (24) of the case being designed to be in electrical contact with a first face (42) of the second card (4), the upper part (23) of the case being designed to be in contact with a second face (43) of the second card (4) except in the region of said slot (21), the upper part (22) of the slot being designed to be in contact with a first face of the first card (3) and the second face of the first card being designed to be in electrical contact with the second face of the second card via said seal (5') and said linking piece (27).

7. Screening device according to Claim 6, **characterized in that** it has another conducting seal (5) designed to be placed between the first card and the upper part (22) of the slot (21).

## Patentansprüche

1. Vorrichtung zum Abschirmen einer elektronischen Schaltungskarte vor elektromagnetischer Strahlung, wobei die Vorrichtung umfasst: ein Gehäuse (2) das aus einem elektrisch leitenden Material hergestellt ist, das mit einem Schlitz (21) versehen ist, in dem ein erster Teil (30) einer ersten elektronischen Schaltungskarte (3) angeordnet ist, wobei sich ein zweiter Teil (31) dieser ersten Karte außerhalb des Gehäuses befindet, wobei die Abschirmvorrichtung außerdem ein komprimierbares leitendes Material (5, 5') enthält, das sich zwischen den Kanten des Schlitzes (21) in dem Gehäuse (2) und den Flächen (32, 33) der ersten Karte (3) befindet, wobei das Gehäuse dafür ausgelegt ist, außerdem eine zweite elektronische Schaltungskarte (4) aufzunehmen, **dadurch gekennzeichnet, dass** die Vorrichtung außerdem ein "Z"-förmiges Verbindungsstück (27) zum elektrischen Verbinden der zwei Karten miteinander enthält, wobei ein unterer, flacher Teil (28) dieses Stücks mit der zweiten Karte (4) in Kontakt steht und ein oberer, flacher Teil (29) dieses Stücks über eine Dichtung (5'), die aus elektrisch leitendem Material hergestellt ist, mit der ersten Karte in Kontakt steht.

2. Abschirmvorrichtung nach Anspruch 1, **dadurch gekennzeichnet, dass** sie die ersten Karte (3) enthält und dass die Flächen der ersten Karte metallisierte Gebiete in diesen Gebieten in Kontakt mit dem komprimierbaren leitenden Material (5, 5') aufweisen.

3. Abschirmvorrichtung nach einem der Ansprüche 1 und 2, **dadurch gekennzeichnet, dass** mindestens eine der Kanten des Schlitzes (21) in dem Gehäuse (2) einen Rand (22) bildet, der parallel zu der Ebene der ersten Karte (3) zurückgebogen ist.

4. Abschirmvorrichtung nach einem der vorhergehenden Ansprüche, **dadurch gekennzeichnet, dass** dann, wenn die Vorrichtung beide Karten enthält, die zweite Karte (4) eine Modemkarte ist und die erste Karte (3) eine Kommunikationskarte mit einer Antennenschaltung in ihrem zweiten Teil (31) ist.

5. Abschirmvorrichtung nach einem der vorhergehenden Ansprüche, **dadurch gekennzeichnet, dass** das Gehäuse (2) so ausgelegt ist, dass die erste Karte (3) eine kleinere Breite als die Breite der zweiten Karte (4) aufweist.

6. Abschirmvorrichtung nach einem der vorhergehenden Ansprüche, **dadurch gekennzeichnet, dass** das Gehäuse in zwei Teilen (23, 24) hergestellt ist, wobei der untere Teil (24) des Gehäuses so ausgelegt ist, dass er mit einer ersten Fläche (42) der zweiten Karte (4) in elektrischem Kontakt steht, dass der obere Teil (23) des Gehäuses so ausgelegt ist, dass er außer in dem Gebiet des Schlitzes (21) mit einer zweiten Fläche (43) der zweiten Karte (4) in Kontakt steht, dass der obere Teil (22) des Gehäuses so ausgelegt ist, dass er mit einer ersten Fläche der ersten Karte (3) in Kontakt steht, und dass die zweite Fläche der ersten Karte so ausgelegt ist, dass sie über die Dichtung (5') und das Verbindungsstück (27) mit der zweiten Fläche der zweiten Karte in elektrischem Kontakt steht.

7. Abschirmvorrichtung nach Anspruch 6, **dadurch gekennzeichnet, dass** sie eine weitere leitende Dichtung (5) aufweist, die so ausgelegt ist, dass sie zwischen der ersten Karte und dem oberen Teil (22) des Schlitzes (21) angeordnet ist.

## Revendications

1. Dispositif de blindage d'une carte de circuit électronique à partir d'une radiation électromagnétique, comprenant un boîtier (2) fait dans un matériau conducteur électrique, fourni avec une encoche (21) dans laquelle une première partie (30) d'une première carte de circuit électronique (3) est placée, une seconde partie (31) de cette première carte étant située à l'extérieur du boîtier, ledit dispositif de blindage comprenant également un matériau conducteur compressible (5, 5') situé entre les bords de l'encoche (21) dans le boîtier (2) et les faces (32, 33) de la première carte (3), ledit boîtier étant conçu pour recevoir une deuxième carte de circuit électronique (4), **caractérisé en ce que** ledit équipement inclut également une section de liaison en Z (27) pour la connexion électrique des deux cartes, une partie plane inférieure (28) de cette section étant en contact avec la deuxième carte (4) et une partie plane supérieure (29) de cette section étant en contact avec la première carte via un joint (5') fait dans un matériau conducteur électrique.

2. Dispositif de blindage selon la revendication 1, **caractérisé en ce qu'**il inclut ladite première carte (3) et **en ce que** les faces de ladite première carte présentent des zones métallisées dans les zones en contact avec le matériau conducteur compressible (5, 5').

3. Dispositif de blindage selon l'une des revendications 1 et 2, **caractérisé en ce qu'**au moins l'un desdits bords de ladite encoche (21) dans le boîtier (2) forme une bordure (22) repliée vers l'arrière parallèlement au plan de ladite première carte (3).

4. Dispositif de blindage selon l'une quelconque des revendications précédentes, **caractérisé en ce que**, lorsque ledit dispositif inclut les deux cartes, la deuxième carte (4) est une carte modem et la première carte (3) est une carte de communication disposant d'un circuit antenne dans sa deuxième partie (31).

5. Dispositif de blindage selon l'une quelconque des revendications précédentes, **caractérisé en ce que** le boîtier (2) est conçu de telle sorte que la largeur de la première carte (3) soit moindre que celle de la deuxième carte (4).

6. Dispositif de blindage selon l'une quelconque des revendications précédentes, **caractérisé en ce que** le boîtier est composé de deux parties (23, 24), la partie inférieure (24) du boîtier étant conçue pour être en contact électrique avec une première face (42) de la deuxième carte (4), la partie supérieure (23) du boîtier étant conçue pour être en contact avec une deuxième face (43) de la deuxième carte (4) excepté dans la zone de ladite encoche (21), la partie supérieure (22) de l'encoche étant conçue pour être en contact avec une première face de la première carte (3) et la seconde face de la première carte étant conçue pour être en contact électrique avec la seconde face de la seconde carte via ledit joint (5') et la dite section de liaison (27).

7. Dispositif de blindage selon la revendication 6, **caractérisé en ce qu'**il dispose d'un autre joint conducteur (5) conçu pour être placé entre la première carte et la partie supérieure (22) de l'encoche (21).
